# EUROPÄISCHE PATENTSCHRIFT

(11) **EP 2 614 693 B1**
(45) Veröffentlichungstag und Bekanntmachung des Hinweises auf die Patenterteilung: **08.05.2019**
(21) Anmeldenummer: 11757165.3
(22) Anmeldetag: 29.08.2011
(51) Int. Cl.: F21K 9/90, H05K 1/02, H05K 3/28, H01L 21/56, H01L 23/24, H01L 23/31, H01L 33/54, H01L 33/56, H01L 31/0203, H01L 31/0232, H01L 27/144, H01L 27/15, F21Y 115/10

(54) **VERFAHREN ZUR BESCHICHTUNG EINES OPTOELEKTRONISCHEN CHIP-ON-BOARD-MODULS UND OPTOELEKTRONISCHES CHIP-ON-BOARD-MODUL**
METHOD FOR COATING AN OPTOELECTRONIC CHIP-ON-BOARD MODULE AND OPTOELECTRONIC CHIP-ON-BOARD-MODULE
PROCÉDÉ POUR RECOUVRIR UN MODULE PUCE-SUR-PLAQUE OPTOÉLECTRONIQUE D'UN REVÊTEMENT, ET MODULE PUCE-SUR-PLAQUE OPTOÉLECTRONIQUE

(30) Priorität: 06.09.2010 DE 102010044470
(43) Veröffentlichungstag der Anmeldung: 17.07.2013
(73) Patentinhaber: Heraeus Noblelight GmbH, 63450 Hanau (DE)
(72) Erfinder: PEIL, Michael, 64853 Otzberg (DE); OSWALD, Florin, 60329 Frankfurt am Main (DE); MAIWEG, Harald, 41352 Korschenbroich (DE)
(74) Vertreter: Heraeus IP
(86) Internationale Anmeldenummer: PCT/EP2011/004327
(87) Internationale Veröffentlichungsnummer: WO 2012/031704

(56) Entgegenhaltungen:
- WO-A1-01/88978
- WO-A1-98/23427
- WO-A2-2008/109813
- US-A1- 2007 278 512
- US-A1- 2007 289 129
- US-A1- 2008 112 162
- US-A1- 2009 134 414
- US-A1- 2009 166 657
- US-A1- 2010 051 988
- US-A1- 2010 078 664

## Beschreibung

Die Erfindung betrifft ein Verfahren zur Beschichtung eines optoelektronischen Chip-On-Board-Moduls, das einen flächigen Träger umfasst, der mit einer oder mehreren optoelektronischen Komponenten bestückt ist, mit einer transparenten, UV- und temperaturbeständigen Beschichtung aus einem oder mehreren Silikonen, ein entsprechendes optoelektronisches Chip-On-Board-Modul und ein System mit mehreren optoelektronischen Chip-On-Board-Modulen.

Gattungsgemäße optoelektronische Chip-On-Board-Module werden beispielsweise als Leuchtkörper, als Hochleistungs-UV-LED-Lampen, als Photovoltaik-Module, Sensoren o. ä. verwendet. Bei den dabei verwendeten optoelektronischen Komponenten handelt es sich im Rahmen der Erfindung beispielsweise, aber nicht ausschließlich, um LEDs oder Photodioden in Form von Chips oder anderen Bauteilen, die im Chip-On-Board-Modul auf einem flächigen Träger, also einem Metall-, Keramik- oder Siliziumsubstrat, einer Metallkern- oder FR4-Leiterplatte, einem Glasträger, einem Kunststoffträger o. ä. angeordnet sind. Diese Chip-On-Board-Module müssen vor mechanischen Schäden und Korrosion geschützt werden. Hierzu werden möglichst kompakte und leichte Lösungen gesucht.

Ein Schutz in der Form von Gehäusen auf Chip-On-Board-Modulen ist oft kostenaufwändig und technologisch aufwändig. Eine praktikable Alternative zum Schutz von Chip-On-Board-Modulen stellt ein flächiger Verguss der Komponenten mit einem kunststoffbasierten Vergussmaterial dar. Zusammen mit weiteren funktionalen Komponenten, wie etwa Leiterbahnen und Kontaktierungselementen, werden die optoelektronischen Komponenten in Chip-On-Board-Modulen zusammen mit einem flächigen Träger durch Beschichtungen vor mechanischen Schäden und Korrosion geschützt.

Üblicherweise werden hierfür Epoxidharze verwendet. Diese werden als Vergussmaterial zunächst flüssig aufgebracht und dann thermisch und/oder strahlungsinduziert ausgehärtet. Da das Vergussmaterial zunächst flüssig ist, muss ein Wegfließen der Vergussmasse vermieden werden. Dies geschieht üblicherweise durch eine Form oder einen festen Rahmen.

Eine Alternative hierfür bildet das so genannte "Dam-and-Fill"-Verfahren, worin zunächst ein Kunststoffdamm auf den Träger des Chip-On-Board-Moduls aufgebracht wird, der eine Fläche des Trägers umschließt, in die anschließend eine flüssige Füllmasse aus Epoxidharz eingefüllt wird. Diese wird ausgehärtet. Damm und Füllmasse bilden zusammen die Beschichtung des Moduls. Zur Erzeugung des Damms wird bei diesem Verfahren ein zähflüssiges Polymer mit einer Dispensvorrichtung aufgebracht bzw. gezogen und danach ausgehärtet, so dass auf die von dem Damm eingeschlossene Fläche Vergussmaterial vergossen werden kann, ohne dass dieses wegfließt.

Der so erzeugte Kunststoffdamm ist allerdings nicht transparent. Daher sind derart beschichtete optoelektronische Chip-On-Board-Module, also Chip-On-Board-Module, die mit optoelektronischen Komponenten, wie beispielsweise LEDs oder Photodioden, bestückt sind, zum Rand hin in ihrer Lichtstrahlungsstärke bzw. ihrer Lichtempfindlichkeit beeinträchtigt.

Eine Klasse weiterer Materialien, die als Damm in einem "Dam-and-Fill"-Verfahren verwendbar sind, sind thixotropierte Epoxidharze. Diese werden für diesen Zweck beispielsweise in der Chip-Karten-Herstellung eingesetzt. Thixotropierte Epoxidharze sind so behandelt, dass ihre Viskosität von der mechanischen Krafteinwirkung und deren Dauer abhängt. Bei thixotropen Epoxidharzen erfolgt daher eine Verflüssigung durch die Krafteinwirkung beim Aufbringen des Dammes und eine anschließende Verfestigung durch die Entspannung des Materials nach dem Austritt aus einer Düse. Damit sind sie zur Erzeugung eines stabilen Dammes in einem "Dam-and-Fill"-Verfahren gut geeignet. Epoxidharze sind jedoch nicht UV-stabil und deshalb in einem Hochleistungs-UV-LED-Modul oder auch bei intensiver Sonneneinstrahlung mit UV-Anteilen, wie sie in der Photovoltaik vorkommen, nicht stabil. Sie altern bei UV-Belastung schnell und werden zerstört.

Bislang ist kein Verfahren zur Realisierung einer flächigen Beschichtung für Chip-On-Board-Module bekannt, in dem sowohl im Flächen- als auch im Randbereich des Vergusses Materialien eingesetzt werden, die sowohl UV-stabil als auch temperaturstabil sind und die darüber hinaus ebenso für elektromagnetische Strahlung vom ultravioletten bis zum infraroten Spektralbereich transparent sind.

Andere Lösungen, wie beispielsweise das Aufkleben eines Glasrahmens oder einer Glaskuppe, die transparent, UV- und temperaturstabil sind, erfordern eine sehr aufwändige Montage des Rahmens und eine schwierig herzustellende Kompaktheit des Rahmens. Zudem ist eine solche Lösung mit einem höheren Gewicht verbunden als eine "Dam-and-Fill"-Lösung. Für starre Glasmaterialien stellt eine meist notwendige Anpassung der thermischen Ausdehnungskoeffizienten der Verbundmaterialien zudem eine weitere Hürde dar, insbesondere wenn die späteren Produkte thermischen Zyklen ausgesetzt sind.

Bei einer Kombinationslösung aus einem Glasrahmen und einem Verguss mit einem geeigneten nicht-epoxidbasiertem Material, wie z.B. einem temperatur- und UV-stabilen Silikon können kleinste Spalten zwischen Rahmen und Substrat dazu führen, dass das stark kriechfähige Silikon beim Vergießen auslaufen könnte. Außerdem muss auf dem Substrat Platz für den Rahmen vorgesehen werden. Dies beeinträchtigt eine bestmögliche Ausnutzung der Substratfläche und/oder eine gewünschte Anreihbarkeit.

Für den Einsatz von Chip-On-Board-Technologie zur Herstellung von Hochleistungs-UV-LED-Modulen, die flächig abstrahlen, oder von Photodioden-Arrays, ist ein flächiger Verguss, der die genannten Nachteile vermeidet, vorteilhafter. Aus Gründen der optischen Effizienz und einer bestmöglichen Anreihbarkeit von Modulen sollte der Verguss sowohl in Flächen als auch im Randbereich transparent sein. Ebenso sind eine hohe Temperatur- und UV-Stabilität sowohl für die Fertigung entsprechender optoelektronischer Bauteile als auch für langzeitstabile Funktionalität relevant.

Weiterhin sind die Druckschriften US 2009/0166657 A1, US 2010/078664 A1, WO 98/23427 A1, US 2007/0278512 A1 und WO 01/88978 A1 als Stand der Technik bekannt.

Ausgehend von diesem Stand der Technik und diesen Anforderungen liegt der vorliegenden Erfindung die Aufgabe zugrunde, ein Verfahren zur Beschichtung eines optoelektronischen Chip-On-Board-Moduls sowie ein entsprechendes beschichtetes optoelektronisches Chip-On-Board-Modul zur Verfügung zu stellen, bei denen eine UV- und temperaturbeständige Beschichtung realisiert wird und eine möglichst effiziente Ausnutzung der auf dem Chip-On-Board-Modul verfügbaren Fläche erreicht wird.

Diese Aufgabe wird erfindungsgemäß durch ein Verfahren zur Beschichtung eines optoelektronischen Chip-On-Board-Moduls, das einen flächigen Träger umfasst, der mit einer oder mehreren optoelektronischen Komponenten bestückt ist, mit einer transparenten, UV- und temperaturbeständigen Beschichtung aus einem oder mehreren Silikonen, gelöst, wie es im Anspruch 1 definiert ist.

Das erfindungsgemäße Verfahren beruht auf dem Grundgedanken, dass Silikone als Dammmaterial in einem modifizierten "Dam-and-Fill"-Verfahren verwendet werden. Dies war bisher nicht möglich, da Silikone nicht thixotropiert werden können, ohne ihre Transparenz zu verlieren. Anstelle einer Thixotropierung der Silikone werden erfindungsgemäß hochreaktive Silikone verwendet, die auf den vorgewärmten Träger appliziert werden. Da der Träger auf eine Temperatur vorgewärmt ist, bei der das hochreaktive Silikon aushärtet und außerdem das Volumen und die Masse des als Dammmaterial verwendeten hochreaktiven Silikons sehr gering ist, härtet das applizierte Dammmaterial sehr schnell aus, bevor es verfließen kann. Auf diese Weise lassen sich erhabene Geometrien verwirklichen.

Als hochreaktives Silikon wird ein bei der ersten Temperatur schnell vernetzendes bzw. aushärtendes Silikon verstanden, das in dem erfindungsgemäßen Verfahren beim Auftreffen auf den Träger einen transparenten Damm bildet, ohne zu zerfließen. Die Aushärtezeit liegt vorzugsweise im Bereich bis zu 10 Sekunden, vorzugsweise weniger als 5 Sekunden. Derartige Silikone sind bekannt. Eine Beschleunigung der Aushärtung kann auch erzielt werden, wenn das erste Silikon strahlungsempfindliche Initiatoren enthält und nach dem Applizieren mit Strahlung, insbesondere sichtbarem oder ultraviolettem Licht, bestrahlt wird, so dass eine Vorvernetzung initiiert wird, während die Vernetzung in der Hauptsache thermisch geschieht.

Da auf diese Art und Weise ein Damm aus Silikon in Form eines Beckens oder Rahmens auf den Träger appliziert wird, kann das durch den Damm vorgegebene Becken anschließend in einem "Dam-and-Fill"-Prozess mit flüssigem Silikon ausgefüllt werden, das danach in der Regel thermisch ausgehärtet wird. Auch eine Aushärtung mittels Strahlung kann alternativ oder zusätzlich dazu verwendet werden. Die Applikation des Dammes erfolgt in einer Relativbewegung von Dispensvorrichtung bzw. Düse und Modul, wobei die Dispensvorrichtung ortsfest sein kann und das Modul bewegt wird, oder umgekehrt.

Der Silikondamm ist erfindungsgemäß ebenso transparent wie die Silikonfüllung, so dass keinerlei optische Beeinträchtigung durch den Silikondamm eintritt. Der flächige Verguss ist somit voll funktional. Hierdurch wird die Effizienz der Beschichtung wesentlich erhöht und es ist möglich, die auf dem Träger verfügbare Fläche weiter auszunutzen, als dies bisher der Fall war, da herkömmliche Dämme intransparent waren und die von den Dämmen überdeckte Fläche nicht für optoelektronische Komponenten verfügbar war.

Bei dem erfindungsgemäßen Verfahren ist die erste Temperatur im Verfahrensschritt a) eine Temperatur von üblicherweise zwischen 100°C und 150°C oder darüber, die angepasst ist, um ein schnelles Aushärten des hochreaktiven Silikons für den Damm zu ermöglichen, ohne die optoelektronischen Komponenten auf dem Träger zu beschädigen.

Um das Auffüllen der von dem Damm eingeschlossenen Fläche oder Teilfläche des Träger gleichmäßig und lückenlos sicherzustellen, ist in einer vorteilhaften Weiterbildung vorgesehen, dass nach dem Schritt b) und vor dem Schritt c) der Träger auf eine zweite Temperatur abgekühlt wird und/oder abkühlen gelassen wird, die unterhalb der ersten Temperatur, insbesondere auch unterhalb einer Aushärtetemperatur des zweiten Silikons, liegt. Dies ist insbesondere dann vorteilhaft, wenn das zweite Silikon bei der ersten Temperatur ebenfalls aushärtet. Bei dem auf die zweite Temperatur abgekühlten Träger kann sich das zweite Silikon gleichmäßig verteilen, ohne auszuhärten und nach der gleichmäßigen und lückenlosen Verteilung im nächsten Schritt ausgehärtet werden. Dies kann wiederum durch Erhöhung der Temperatur und/oder durch Strahlungsaushärtung geschehen.

Zusätzlich oder alternativ ist vorzugsweise vorgesehen, dass das zweite Silikon gleich reaktiv oder weniger reaktiv ist als das zur Erzeugung eines Dammes verwendete erste Silikon, oder das gleiche Silikon als erstes Silikon und als zweites Silikon verwendet wird. Wenn das zweite Silikon weniger reaktiv ist, kann eine lückenlose und gleichmäßige Auffüllung der von dem Damm umschlossenen Fläche auch dann erfolgen, wenn die Temperatur des Trägers nicht oder nur geringfügig herabgesetzt worden ist.

Eine vorteilhafte, besonders effiziente Ausnutzung der auf dem Träger vorhandenen Fläche ist möglich, wenn der Damm wenigstens abschnittsweise am Rand des Trägers aufgetragen wird. Somit ist es möglich, die Designfreiheit zu erhöhen und insbesondere die gesamte Fläche des Trägers transparent und UV- und temperaturbeständig zu beschichten.

Weiter vorzugsweise wird der Damm über optoelektronische Komponenten, Bond-Drähte oder andere Bauteile aufgetragen, so dass die Flächenausnutzung der Beschichtung nicht davon begrenzt wird, dass auf die Anordnung von optischen Chips, Bond-Drähten oder anderen Bauteilen Rücksicht genommen werden muss. Vielmehr kann der Damm in beliebiger Weise auf dem Träger angeordnet werden.

Eine vorteilhafte Weiterbildung erfährt das Verfahren, wenn der Damm mit einem Querschnittsprofil aufgetragen wird, das eine optische Bündelung oder Zerstreuung von Licht bewirkt. Dadurch kann die Lichtausbeute im Randbereich nach Wunsch modelliert werden. Dies verbessert auch die Anreihbarkeit benachbarter Module, da Abschattungen im Randbereich vermieden werden. Die Form des Dammes wird durch das spontane Aushärten des Silikonmaterials für den Damm und die Beeinflussung von dessen Härtungseigenschaften durch die Abstimmung der Prozessparameter ermöglicht. Die entsprechenden Prozessparameter sind insbesondere die Reaktivität des verwendeten Silikonmaterials, die Temperatur des Trägers und die Auftragsgeschwindigkeit des Dammes sowie die Form der verwendeten Düse, sowie ein Abstand zwischen der verwendeten Düse und dem Träger.

Vorzugsweise sind oder werden in das erste Silikon und/oder das zweite Silikon optisch funktionale Materialien, insbesondere phosphoreszierende und/oder streuende Materialien oder Partikel, eingemischt. Phosphoreszierende Materialien sorgen für eine Wellenlängenverschiebung, so dass eine gewünschte Einstellung der emittierten Wellenlänge u. a. bei LED-Modulen möglich ist. Streuende Partikel und Materialien sorgen dafür, dass eine gleichmäßige Beleuchtung bzw. Lichtausstrahlung, insbesondere bei Lampenmodulen, erzeugt wird. Andere beimischbare Materialien sind beispielsweise farbabsorbierende bzw. farbaktive Materialien.

Eine ebenfalls vorteilhafte Weiterbildung erfährt das erfindungsgemäße Verfahren, wenn Tropfen des ersten Silikons als schnell aushärtende Linsen auf einzelne optoelektronische Komponenten des Trägers aufgetragen werden. Diese Tropfen bilden in diesem Fall Inseln innerhalb des von dem Damm umschlossenen Bereiches und bestimmen die optischen Eigenschaften der Beschichtung oberhalb der optoelektronischen Komponenten auf dem Träger. Um diese tropfenförmigen Linsen herum wird anschließend die von dem Damm umschlossene Fläche mit dem zweiten Silikon verfüllt. Dabei ragen die Linsen vorzugsweise aus dem zweiten Silikon heraus.

Besonders fehlstellenfreie Beschichtungen ergeben sich, wenn das erste und/oder das zweite Silikon unter einem Vakuum, insbesondere bei etwa 10 mbar, vorbehandelt wird. Hierdurch wird im flüssigen Silikon eingeschlossenes Gas aus dem Silikon extrahiert. Die Applikation und/oder das Aushärten des ersten und/oder des zweiten Silikons kann vorteilhafterweise unter einem atmosphärischen Überdruck, insbesondere zwischen 4 bis 10 bar, insbesondere bei etwa 5 bis 7 bar, erfolgen. Hierdurch werden beim Vergießen erzeugte und im Silikon eingeschlossene Gasblasen so weit verkleinert, dass sie verschwinden und das darin enthaltene Gas störungsstellenfrei in das Silikon und durch das Silikon hindurch diffundiert.

Die der Erfindung zugrunde liegende Aufgabe wird auch durch ein optoelektronisches Chip-On-Board-Modul nach dem Anspruch 9 gelöst. Ein solches erfindungsgemäßes optoelektronisches Chip-On-Board-Modul ist in beliebiger Weise, insbesondere vollflächig, mit einer transparenten, UV- und temperaturbeständigen Beschichtung versehen, so dass gegebenenfalls die gesamte Fläche eines Trägers für optische Komponenten zur Verfügung steht. Die Anordnung der optoelektronischen Komponenten auf dem Träger ist somit nicht durch Vorgaben und Zwänge der Beschichtung begrenzt.

Mit entsprechenden Silikonen ist ein UV-stabiler Schutz bis hin zu Intensitäten zu einigen 10 W/cm² bis zu einer Temperatur von typischerweise ca. 200°C gegeben. Dieser Schutz umfasst sowohl den Flächenbereich als auch den Randbereich des Trägers bzw. des Chip-On-Board-Moduls unterhalb der Beschichtung und schützt das Modul und die Verbindungsbauteile auch mechanisch.

Das erfindungsgemäße optoelektronische Chip-On-Board-Modul ist nach dem oben beschriebenen erfindungsgemäßen Verfahren hergestellt. Damit weist es auch die bereits im Zusammenhang mit dem erfindungsgemäßen Verfahren beschriebenen Eigenschaften und Vorteile auf.

Vorzugsweise verläuft der Damm wenigstens abschnittsweise an einem Rand des Trägers (2, 2'). Damit ist es möglich, die auf dem Träger vorhandene Fläche optimal für optoelektronische Komponenten nach Wunsch auszunutzen. Ein aus produktionstechnischen Gründen von einer Beschichtung frei gelassener Rand ist entbehrlich.

Vorzugsweise bestehen das erste Silikon und das zweite Silikon aus dem gleichen Material oder weisen im ausgehärteten Zustand gleiche optische Eigenschaften, insbesondere in Bezug auf Transparenz, Farbe und/oder Brechungsindex, auf. Damit weist die Beschichtung des Chip-On-Board-Moduls insgesamt vorzugsweise in jedem Punkt gleiche oder gleichartige optische Eigenschaften auf. Zusätzlich kann der Damm im Querschnitt vorteilhafterweise so geformt sein, dass er strahlbündelnde oder -zerstreuende Eigenschaften aufweist.

Vorzugsweise ist der Träger bis an einen Rand oder bis kurz vor einen Rand mit optoelektronischen Komponenten bestückt, so dass die auf dem Träger zur Verfügung stehende Fläche optimal ausgenutzt wird und die optoelektronischen Komponenten geschützt sind.

Die der Erfindung zugrunde liegende Aufgabe wird außerdem durch ein System mit zwei oder mehreren erfindungsgemäßen oben beschriebenen optoelektronischen Chip-On-Board-Modulen gelöst, wobei die Träger der optoelektronischen Chip-On-Board-Module bündig nebeneinander angeordnet sind, wobei sich insbesondere aufgrund einer randständigen Bestückung der Träger mit optoelektronischen Komponenten eine auch über die Grenzen zwischen benachbarten Trägern hinweg regelmäßige Anordnung und Beabstandung von optoelektronischen Komponenten ergibt. Damit ist auch bei der Zusammenfügung mehrerer Chip-On-Board-Module eine gleichmäßige und randlose Ausnutzung der zur Verfügung stehenden Fläche mit optischen Komponenten, beispielsweise LEDs oder Photodioden, möglich.

Den Erfindungsgegenständen, also dem erfindungsgemäßen Verfahren, dem erfindungsgemäßen optoelektronischen Chip-On-Board-Modul und dem erfindungsgemäßen System, ist gemeinsam, dass die Härte des Silikon gewählt werden kann, typischerweise zwischen einem Gel und einer Shore-Härte nahe 100, so dass thermisch induzierte Spannungen gedämpft werden können, die durch unterschiedliche Ausdehnungskoeffizienten zwischen Träger, Chip-On-Board-Bauteilen und Verbindungsmaterialien auftreten.

Auch die weiteren zu den einzelnen Erfindungsgegenständen oben genannten Merkmale, Eigenschaften und Vorteile gelten ohne Einschränkung auch für die jeweils anderen Erfindungsgegenstände.

Die Erfindung wird nachstehend ohne Beschränkung des allgemeinen Erfindungsgedankens anhand von Ausführungsbeispielen unter Bezugnahme auf die Zeichnungen beschrieben, wobei bezüglich aller im Text nicht näher erläuterten erfindungsgemäßen Einzelheiten ausdrücklich auf die Zeichnungen verwiesen wird. Es zeigen:
- Fig.1: eine schematische Darstellung eines Chip-On-Board-LED-Moduls,
- Fig. 2: eine schematische Darstellung eines Systems mit zwei Chip-On-Board-LED-Modulen mit herkömmlichen Dämmen,
- Fig. 3: eine schematische Darstellung eines auf herkömmliche Weise beschichteten Chip-On-Board-LED-Moduls und
- Fig. 4: eine schematische Darstellung eines erfindungsgemäß beschichteten Chip-On-Board-LED-Moduls.

In den folgenden Figuren sind jeweils gleiche oder gleichartige Elemente bzw. entsprechende Teile mit denselben Bezugsziffern versehen, so dass von einer entsprechenden erneuten Vorstellung abgesehen wird.

Die Erfindung wird anhand von Chip-On-Board-LED-Modulen, also anhand von Leuchtkörpern, als Beispiel für optoelektronische Chip-On-Board-Module erläutert. Im Rahmen der Erfindung können anstatt von LED-Modulen als optoelektronische Komponenten auch Photodioden in Solarzellen oder andere Komponenten Anwendung finden.

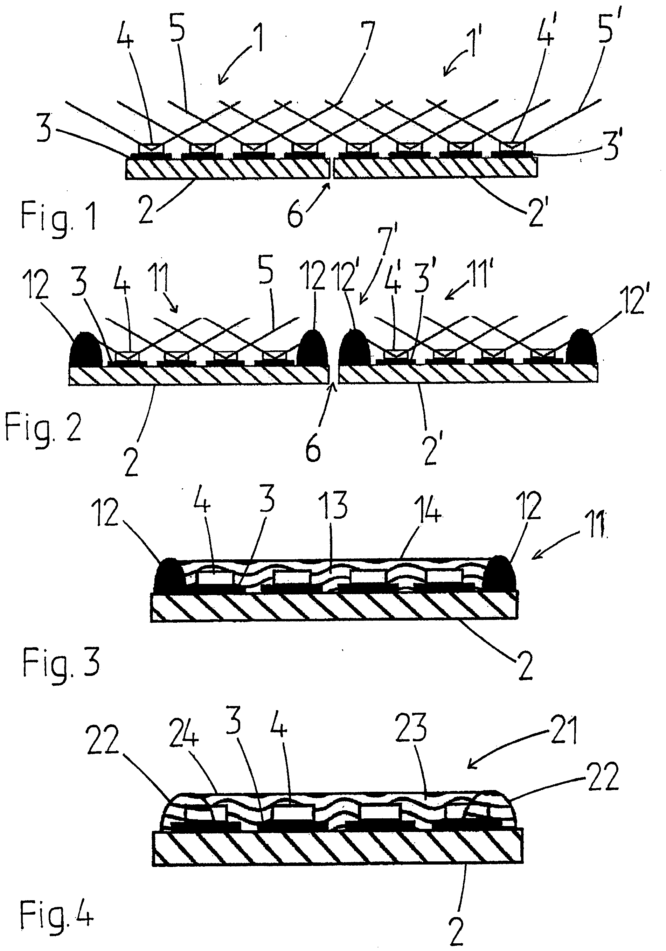

In Fig. 1 ist ein Chip-On-Board-LED-Modul 1 ohne Beschichtung im Querschnitt schematisch gezeigt, bei dem auf zwei parallel angeordneten Trägern 2, 2' bzw. Substraten Leiterbahnen 3, 3' und als unbehauste LED-Chips ausgebildete LEDs 4, 4' in regelmäßigem Abstand angeordnet sind. Aus Gründen der Übersichtlichkeit sind nicht alle wiederkehrenden Elemente der Fig. 1 und der folgenden Figuren mit Bezugszeichen versehen, diese beziehen sich jedoch auf alle gleichartigen Elemente. Es ist somit in Fig. 1 jeweils nur eine LED 4, 4' für jedes der beiden Chip-On-Board-LED-Module 1,1' mit einer Bezugsziffer versehen. Die anderen Komponenten sind jeweils gleichartig.

Ein Träger 2, 2' kann beispielsweise ein in starrer, halbflexibler oder flexibler Substrattechnologie aufgebautes Metall-, Keramik- oder Siliziumsubstrat, eine Metallkern- oder FR4-Leiterplatte, ein Glasträger oder ein Kunststoffträger Metallkernleiterplatte sein.

Mit Linien sind Lichtkegel 5, 5' der LEDs 4, 4'dargestellt. Die LEDs sind näherungsweise Lambert'sche Strahler, die ca. 75% der gesamten abgestrahlten Lichtleistung innerhalb eines Öffnungswinkels von 120° abstrahlen. Ist die mit LEDs 4, 4' bestückte Fläche gegenüber dem Messabstand ausgedehnt und der Abstand hinreichend größer als der Abstand der LEDs-Chips, auch "Pitch" genannt, dann wird eine homogene Intensitätsverteilung mit ähnlichen Eigenschaften gemessen, wie die einer homogenen, diffus leuchtenden Fläche.

Im in Fig. 1 dargestellten Fall setzt sich die homogene Intensitätsverteilung auch über die Stoßstelle 6 zwischen benachbarten Modulen 1, 1' fort, da der Überlappungsbereich 7 der Lichtkegel 5, 5' an dieser Stelle aufgrund der regelmäßigen und randständigen Bestückung der Träger 2, 2' mit LEDs 4, 4' und dem Fehlen von optischen Hindernissen gut ausgebildet ist.

In Fig. 2 ist schematisch dargestellt, wie ein System aus mehreren Chip-On-Board-Modulen 2, 2', die nebeneinander gesetzt sind, abstrahlt, wenn diese mit einem herkömmlichen "Dam-and-Fill"-Verfahren beschichtet sind. Aus Gründen der Übersichtlichkeit wird von der Beschichtung jeweils nur der Damm 12, 12' aus einem intransparenten Material dargestellt. Wegen der Intransparenz der Dämme 12, 12' werden die Emissionskegel 5, 5' der LEDs 4, 4' an diesen Dämmen 12, 12' abgeschnitten. Entsprechend ergibt sich an der Stoßstelle 6 ein eingeschränkter Überlappungsbereich 7', an dem die Leuchtdichte gegenüber dem in Fig. 1 gezeigten Beispiel deutlich reduziert ist.

Hinzu kommt, dass die herkömmlichen Dämme 12, 12' nicht auf den LEDs 4, 4' verlegt werden können, sondern einen eigenen Platz benötigen. Der Randbereich der Träge 2, 2' ist muss daher auf den Chip-On-Board-LED-Modulen 11, 11' in Fig. 2 von LEDs 4, 4' freibleiben. Diese vergrößerte Beabstandung an den Rändern der Träger 2, 2' führt zu einer weiteren Verschlechterung der Homogenität der Lichtabstrahlung an der Stoßstelle 6.

In Fig. 3 ist schematisch ein Chip-On-Board-LED-Modul 11 dargestellt, wie es auch in Fig. 2 dargestellt ist, allerdings in diesem Fall ohne die Lichtkegel 5, 5', dafür aber mit der Darstellung der Füllmasse 13 aus Epoxidharz. Die Beschichtung aus den Dämmen 12 und dem Epoxidharz 13 schützen die optoelektronischen Komponenten, d.h. die LEDs 4 und die Leiterbahnen sowie den Träger 2 des Chip-On-Board-LED-Moduls 11 mechanisch, sie sind jedoch nicht UV-fest.

Außerdem ist der Damm 12 nicht transparent.

In Fig. 4 ist schematisch ein erfindungsgemäßes Chip-On-Board-LED-Modul 21 gezeigt, das neben den üblichen Komponenten Träger 2, Leiterbahnen 3 und LEDs 4 eine Beschichtung 24 aus einem Damm 22 aus einen hochreaktiven Silikon und einer Füllmasse 23 aus einem Silikon aufweist. Diese Beschichtung 24 ist sowohl in der Füllmasse 23 als auch im Damm 22 transparent, so dass die LEDs 4 bis an den Rand des Trägers 2 gleichmäßig verteilt angeordnet sein können. Der Damm 22 ist teilweise über die LEDs 4 hinweg auf den Träger 2 aufgetragen, schattet wegen seiner Transparenz allerdings deren Lichtausstrahlung nicht ab.

Die Herstellung erfolgt, in dem zunächst der Träger 2 mit den darauf angeordneten Komponenten, d.h. den Leiterbahnen 3 und den LED-Chips 4, erwärmt wird und anschließend der Damm 22 aus einem hochreaktiven Silikon in gewünschter Weise auf den Träger 2 aufgetragen wird. Da es sich um eine sehr geringe Masse handelt und die Temperatur des Trägers 2 bei oder oberhalb der Auswertetemperatur des Silikon liegt, härtet das Silikon des Dammes 22 aus, bevor es kriechen oder verfließen kann. Auch eine strahlungsinduzierte Vorhärtung kann vorgenommen werden, wenn das Silikon entsprechende Initiatoren enthält. Anschließend wird, nachdem der Damm, der die Höhe der LEDs 4 über dem Träger 2 überragt, mit flüssigem Silikon 23 verfüllt, und anschließend ausgehärtet.

Dieses modifizierte "Dam and Fill"-Verfahren erlaubt erstmals eine transparente, UV- und temperaturbeständige Beschichtung von optoelektronischen Chip-On-Board-Modulen.

### Bezugszeichenliste

- 1, 1': Chip-On-Board-LED-Modul
- 2, 2': Träger
- 3, 3': Leiterbahn
- 4, 4': LED
- 5, 5': Lichtkegel
- 6: Stoßstelle
- 7: Überlappungsbereich
- 7': eingeschränkter Überlappungsbereich
- 11, 11': Chip-On-Board-LED-Modul
- 12, 12': Damm aus thixotropiertem Epoxidharz
- 13: Füllmasse aus Epoxidharz
- 14: Beschichtung
- 21: Chip-On-Board-LED-Modul
- 22: Damm aus einem hochreaktiven Silikon
- 23: Füllmasse aus Silikon
- 24: Beschichtung

## Patentansprüche

1. Verfahren zur Beschichtung eines optoelektronischen Chip-On-Board-Moduls (1, 1', 21), das einen flächigen Träger (2, 2') umfasst, der mit einer oder mehreren optoelektronischen Komponenten (4) bestückt ist, mit einer transparenten, UV- und temperaturbeständigen Beschichtung (24) aus einem oder mehreren Silikonen,
wobei die Beschichtung (24) einen transparenten Damm (22) und eine transparente Füllung (23) aufweist, und wobei das Verfahren die folgenden Verfahrensschritte aufweist:
a) Vorwärmen des zu beschichtenden Trägers (2, 2') auf eine erste Temperatur,
b) Auftragen des eine zu beschichtende Fläche oder Teilfläche des Trägers (2, 2') einschließenden, transparenten Dammes (22) aus einem ersten, thermisch aushärtenden, hochreaktiven Silikon, das bei der ersten Temperatur aushärtet, auf den vorgewärmten Träger (2, 2'),
c) Auffüllen der von dem transparenten Damm (22) eingeschlossenen Fläche oder Teilfläche des Trägers (2, 2') mit einem flüssigen zweiten Silikon (23), und
d) Aushärten des zweiten Silikons (23) unter Erhalt der transparenten Füllung (23),
wobei das erste hochreaktive Silikon ein Silikon ist, das bei der ersten Temperatur innerhalb einer Aushärtezeit vernetzt oder aushärtet, und beim Auftreffen auf den vorgewärmten Träger (2, 2') den transparenten Damm (22) bildet, ohne zu zerfließen,
wobei die Aushärtezeit im Bereich bis zu 10 Sekunden liegt.

2. Verfahren nach Anspruch 1, **dadurch gekennzeichnet, dass** nach dem Schritt b) und vor dem Schritt c) der Träger (2, 2') auf eine zweite Temperatur abgekühlt wird und/oder abkühlen gelassen wird, die unterhalb der ersten Temperatur, insbesondere auch unterhalb einer Aushärtetemperatur des zweiten Silikons (23), liegt.

3. Verfahren nach Anspruch 1 oder 2, **dadurch gekennzeichnet, dass** das zweite Silikon (23) gleich reaktiv oder weniger reaktiv ist als das zur Erzeugung eines Dammes (22) verwendete erste Silikon, oder das gleiche Silikon als erstes Silikon und als zweites Silikon (23) verwendet wird.

4. Verfahren nach einem der Ansprüche 1 bis 3, **dadurch gekennzeichnet, dass** der Damm (22) wenigstens abschnittsweise am Rand des Trägers (2, 2') aufgetragen wird.

5. Verfahren nach einem der Ansprüche 1 bis 4, **dadurch gekennzeichnet, dass** der Damm (22) über optoelektronische Komponenten (4), Bond-Drähte oder andere Bauteile aufgetragen wird.

6. Verfahren nach einem der Ansprüche 1 bis 5, **dadurch gekennzeichnet, dass** der Damm (22) mit einem Querschnittsprofil aufgetragen wird, das eine optische Bündelung oder Zerstreuung von Licht bewirkt.

7. Verfahren nach einem der Ansprüche 1 bis 6, **dadurch gekennzeichnet, dass** in das erste Silikon und/oder das zweite Silikon (23) optisch funktionale Materialien, insbesondere phosphoreszierende und/oder streuende Materialien oder Partikel, eingemischt sind oder werden.

8. Verfahren nach einem der Ansprüche 1 bis 7, **dadurch gekennzeichnet, dass** Tropfen des ersten Silikons als schnell aushärtende Linsen auf einzelne optoelektronische Komponenten (4) des Trägers (2, 2') aufgetragen werden.

9. Optoelektronisches Chip-On-Board-Modul (21), umfassend einen flächigen Träger (2, 2'), der mit einer oder mehreren optoelektronischen Komponenten (4) bestückt ist, mit einer transparenten, UV- und temperaturbeständigen Beschichtung (24) aus einem oder mehreren Silikonen (22, 23), **dadurch gekennzeichnet, dass** die Beschichtung einen eine Fläche oder Teilfläche des Trägers (2, 2') einschließenden transparenten Damm (22) aus einem ausgehärteten ersten Silikon und ein in die Fläche oder Teilfläche eingefülltes, ausgehärtetes und eine transparente Füllung (23) bildendes zweites Silikon (23) umfasst,
**dadurch gekennzeichnet, dass** das optoelektronische Chip-On-Board-Modul (21) nach einem Verfahren nach einem der Ansprüche 1 bis 8 hergestellt ist.

10. Optoelektronisches Chip-On-Board-Modul (21) nach Anspruch 9, **dadurch gekennzeichnet, dass** der Damm (22) wenigstens abschnittsweise an einem Rand des Trägers (2, 2') verläuft.

11. Optoelektronisches Chip-On-Board-Modul (21) nach einem der Ansprüche 9 bis 10, **dadurch gekennzeichnet, dass** das erste Silikon und das zweite Silikon (23) aus dem gleichen Material bestehen oder im ausgehärteten Zustand gleiche optische Eigenschaften, insbesondere in Bezug auf Transparenz, Farbe und/oder Brechungsindex, aufweisen.

12. Optoelektronisches Chip-On-Board-Modul (21) nach einem der Ansprüche 9 bis 11, **dadurch gekennzeichnet, dass** der Träger (2, 2') bis an einen Rand oder bis kurz vor einem Rand mit optoelektronischen Komponenten (4) bestückt ist.

13. System mit zwei oder mehreren optoelektronischen Chip-On-Board-Modulen (21) nach einem der Ansprüche 9 bis 12, **dadurch gekennzeichnet, dass** die Träger (2, 2') der optoelektronischen Chip-On-Board-Module (21) bündig nebeneinander angeordnet sind, wobei sich insbesondere aufgrund einer randständigen Bestückung der Träger (2, 2') mit optoelektronischen Komponenten (4) eine auch über die Grenzen zwischen benachbarten Trägern (2, 2') hinweg regelmäßige Anordnung und Beabstandung von optoelektronischen Komponenten (4) ergibt.

## Claims

1. Method for coating an optoelectronic chip-on-board module (1, 1', 21) that comprises a two-dimensional support (2, 2') that is configured with one or more optoelectronic components (4), with a transparent UV- and temperature-resistant coating (24) made of one or more silicones,
whereby the coating (24) comprises a transparent dam (22) and a transparent filling (23),
and whereby the method comprises the following procedural steps:
a) preheating the support (2, 2') to be coated to a first temperature;
b) applying the transparent dam (22), which encloses a surface or partial surface of the support (2, 2') to be coated and is made of a first heat-curing highly reactive silicone that is cured at the first temperature, onto the preheated support (2, 2');
c) filling the surface or partial surface of the support (2, 2') enclosed by the transparent dam (22) with a liquid second silicone (23); and
d) curing the second silicone (23) while obtaining the transparent filling (23);
whereby the first highly reactive silicone is a silicone that is cross-linked or cured at the first temperature within a curing time and forms the transparent dam (22) without deliquescing when it hits on the preheated support (2, 2'), whereby the curing time is in a range of up to 10 seconds.

2. Method according to claim 1, **characterised in that**, following step b) and before step c), the support (2, 2') is cooled down and/or is allowed to cool down to a second temperature that is below the first temperature, in particular is also below a curing temperature of the second silicone (23).

3. Method according to claim 1 or 2, **characterised in that** the second silicone (23) is as reactive or less reactive than the first silicone used to produce a dam (22) or **in that** the same silicon is used as first silicone and as second silicone (23).

4. Method according to any one of the claims 1 to 3, **characterised in that** the dam (22), at least sections thereof, is applied at the edge of the support (2, 2').

5. Method according to any one of the claims 1 to 4, **characterised in that** the dam (22) is applied over optoelectronic components (4), bond wires or other components.

6. Method according to any one of the claims 1 to 5, **characterised in that** the dam (22) is applied with a cross-sectional profile that effects an optical focusing or diffraction of light.

7. Method according to any one of the claims 1 to 6, **characterised in that** optically functional materials, in particular phosphorescent and/or scattering materials or particles, are admixed or are being admixed to the first silicone and/or the second silicone (23).

8. Method according to any one of the claims 1 to 7, **characterised in that** droplets of the first silicone are being applied onto individual optoelectronic components (4) of the support (2, 2 ') as rapidly curing lenses.

9. Optoelectronic chip-on-board module (21), comprising a two-dimensional support (2, 2') that is configured with one or more optoelectronic components (4), with a transparent UV- and temperature-resistant coating (24) made of one or more silicones (22, 23), **characterised in that** the coating comprises a transparent dam (22), which encloses a surface or partial surface of the support (2, 2') and is made of a cured first silicone, and a second silicone (23), which is being filled into the surface or partial surface, is cured, and forms a transparent filling (23),
**characterised in that** the optoelectronic chip-on-board module (21) is produced according to a method according to any one of the claims 1 to 8.

10. Optoelectronic chip-on-board module (21) according to claim 9, **characterised in that** the dam (22), at least sections thereof, extends along an edge of the support (2, 2').

11. Optoelectronic chip-on-board module (21) according to any one of the claims 9 to 10, **characterised in that** the first silicone and the second silicone (23) consist of the same material or comprise identical optical properties, in particular with regard to transparency, colour and/or refractive index, in cured condition.

12. Optoelectronic chip-on-board module (21) according to any one of the claims 9 to 11, **characterised in that** the support (2, 2') is configured with optoelectronic components (4) up to an edge or up to just before an edge.

13. System with two or more optoelectronic chip-on-board modules (21) according to any one of the claims 9 to 12, **characterised in that** the supports (2, 2') of the optoelectronic chip-on-board module (21) are arranged next to each other such as to be flush, whereby, in particular, the support (2, 2') being configured with optoelectronic components (4) up to the edge results in a regular arrangement and distancing of optoelectronic components (4) even beyond the borders between neighbouring supports (2, 2').

## Revendications

1. Procédé d'enrobage d'un module de montage direct des puces opto-électronique (1, 1', 21) qui comprend un support plan (2, 2') qui est équipé d'un ou plusieurs composants opto-électroniques (4), avec un enrobage transparent (24) résistant aux UV et à la température en une ou plusieurs silicones,
dans lequel l'enrobage (24) présente un barrage transparent (22) et un remplissage transparent (23),
et dans lequel le procédé présente les étapes de procédé suivantes :
a) préchauffage du support à enrober (2, 2') à une première température,
b) application du barrage transparent (22) incluant une surface ou surface partielle à enrober du support (2, 2') en une première silicone hautement réactive, durcissant par voie thermique, qui durcit à la première température sur le support préchauffé (2, 2'),
c) remplissage de la surface ou surface partielle du support (2, 2') inclue par le barrage transparent (22) avec une seconde silicone fluide (23), et
d) durcissement de la seconde silicone (23) avec obtention du remplissage transparent (23),
dans lequel la première silicone hautement réactive est une silicone qui réticule ou durcit à la première température en l'espace d'une durée de durcissement et forme le barrage transparent (22) sans fondre lors de l'impact sur le support préchauffé (2, 2'),
dans lequel la durée de durcissement se situe dans la région allant jusqu'à 10 secondes.

2. Procédé selon la revendication 1, **caractérisé en ce que** le support (2, 2') est refroidi et/ou laissé refroidir à une seconde température après l'étape b) et avant l'étape c) qui se situe en dessous de la première température, notamment également en dessous d'une température de durcissement de la seconde silicone (23).

3. Procédé selon la revendication 1 ou 2, **caractérisé en ce que** la seconde silicone (23) est pareillement réactive ou moins réactive que la première silicone utilisée pour la génération d'un barrage (22), ou la même silicone est utilisée en tant que première silicone et en tant que seconde silicone (23).

4. Procédé selon une des revendications 1 à 3, **caractérisée en ce que** le barrage (22) est appliqué au moins par section sur le bord du support (2, 2').

5. Procédé selon une des revendications 1 à 4, **caractérisée en ce que** le barrage (22) est appliqué au-dessus de composants opto-électroniques (4), fils de connexion ou autres composants.

6. Procédé selon une des revendications 1 à 5, **caractérisée en ce que** le barrage (22) est appliqué avec un profil de section transversale qui entraîne une concentration optique ou dispersion de lumière.

7. Procédé selon une des revendications 1 à 6, **caractérisée en ce que** des matériaux fonctionnels du point de vue optique, notamment des matériaux ou particules phosphorescents et/ou dispersifs, sont mélangés dans la première silicone et/ou la seconde silicone (23).

8. Procédé selon une des revendications 1 à 7, **caractérisée en ce que** des gouttes de la première silicone sont appliquées en tant que lentilles à durcissement rapide sur des composants opto-électroniques individuels (4) du support (2, 2').

9. Module de montage direct des puces opto-électronique (21) comprenant un support plan (2, 2') qui est équipé d'un ou plusieurs composants opto-électroniques (4), avec un enrobage transparent (24) résistant aux UV et à la température en une ou plusieurs silicones (22, 23), **caractérisé en ce que** l'enrobage comprend un barrage transparent (22) incluant une surface ou surface partielle du support (2, 2') en une première silicone durcie et une seconde silicone (23) versée dans la surface ou surface partielle, durcie et formant un remplissage transparent (23),
**caractérisé en ce que** le module de montage direct des puces opto-électronique (21) est fabriqué selon un procédé selon une des revendications 1 à 8.

10. Module de montage direct des puces opto-électronique (21) selon la revendication 9, **caractérisé en ce que** le barrage (22) s'étend au moins par section sur un bord du support (2, 2').

11. Module de montage direct des puces opto-électronique (21) selon une des revendications 9 à 10, **caractérisé en ce que** la première silicone et la seconde silicone (23) se composent du même matériau ou présentent à l'état durci des propriétés optiques identiques, notamment par rapport à la transparence, la couleur et/ou l'indice de réfraction.

12. Module de montage direct des puces opto-électronique (21) selon une des revendications 9 à 11, **caractérisé en ce que** le support (2, 2') est équipé de composants opto-électroniques (4) jusqu'à un bord ou jusqu'à peu avant un bord.

13. Système avec deux ou plusieurs modules de montage direct des puces opto-électroniques (21) selon une des revendications 9 à 12, **caractérisé en ce que** les supports (2, 2') des modules de montage direct des puces opto-électroniques (21) sont disposés à fleur les uns à côté des autres, dans lequel un agencement et un écartement réguliers de composants opto-électroniques (4) également au-delà des limites entre des supports voisins (2, 2') résultent notamment en raison d'un équipement marginal des supports (2, 2') avec des composants opto-électroniques (4).
